# EUROPEAN PATENT SPECIFICATION

(11) **EP 3 870 990 B1**
(45) Date of publication and mention of the grant of the patent: **11.12.2024**
(21) Application number: 19798755.5
(22) Date of filing: 27.10.2019
(51) Int. Cl.: G01R 33/565, G01R 33/567

(54) **SYSTEMS AND METHODS FOR MRI MOTION CORRECTION DURING MRI IMAGE ACQUISITION**
SYSTEME UND VERFAHREN ZUR MRT-BEWEGUNGSKORREKTUR WÄHREND DER ERFASSUNG VON MRT-BILDERN
SYSTÈMES ET PROCÉDÉS DE CORRECTION DE MOUVEMENT D'IRM PENDANT UNE ACQUISITION D'IMAGE D'IRM

(30) Priority: 26.10.2018 US 201862751035 P
(43) Date of publication of application: 01.09.2021
(73) Proprietor: Aspect Imaging Ltd., 60850 Shoham (IL)
(72) Inventor: STRAUSS, Noa, 4927232 Peytah Tikva (IL); AZULAY, Shmuel, 6340506 Tel Aviv (IL)
(74) Representative: Forresters IP LLP
(86) International application number: PCT/IL2019/051156
(87) International publication number: WO 2020/084626

(56) References cited:
- US-A1- 2015 316 635
- HANGYI JIANG ET AL: "Origin and minimization of residual motion-related artifacts in navigator-corrected segmented diffusion-weighted EPI of the human brain", MAGNETIC RESONANCE IN MEDICINE., vol. 47, no. 4, 1 April 2002 (2002-04-01), US, pages 818 - 822, XP055669078, ISSN: 0740-3194, DOI: 10.1002/mrm.10102
- M A FERNANDEZ-SEARA ET AL: "Correction of Motion Artefacts in High Resolution FSE Images", 15 May 2004 (2004-05-15), XP055670212, Retrieved from the Internet <URL:https://cds.ismrm.org/ismrm-2004/Files/002160.pdf> [retrieved on 20200219]

## Description

### TECHNICAL FIELD

The present disclosure generally relates to magnetic resonance imaging ("MRI") and, more specifically to systems and methods for improving MRI image quality in instances where a subject undergoing MRI moves during acquisition of an MRI image.

### BACKGROUND

MRI is a non-invasive imaging technology that creates detailed images of organs and tissues in the body. MRI may be used as a tool to diagnose and/or monitor a variety of health conditions. An MRI device includes a primary magnet which generates a strong primary magnetic field (B₀) that causes the magnetic moments of the protons of the hydrogen atoms in the body to align parallel or antiparallel to the direction of the primary magnetic field, creating a net magnetic vector in the direction of the primary magnetic field. Application of a radiofrequency excitation pulse deflects the net magnetic vector toward a traverse plane perpendicular to the primary magnetic field. When the radiofrequency source is switched off, the protons relax to their resting state and release radiofrequency signals that are detected as data by the MRI device and used to create the MRI image. Proton relaxation may be measured by both T1 relaxation (the time for the net magnetic vector to return to the resting state) and T2 relaxation (the time for the proton axial spins to return to their resting state). Gradient coils may be used to generate gradients of the primary magnetic field, and allow the MRI device to image body parts in selected slices such as selected axial, sagittal, and coronal slices. The data used to create MRI image may be collected row by row in k-space, which is a data grid or matrix where the data is stored prior to application of the Fourier Transform to generate the final image. Each MRI image may be generated by averaging the data from two or more consecutive MRI scans in order to improve the signal-to-noise ratio and image quality.

Movement of or by the patient during acquisition of the MRI image may compromise image quality and resolution. For instance, patient movement due to respiration, heart muscle motion, or even larger body movements may result in undesirable motion artifacts in the resulting MRI image such as ghosting, blurring, or streaking. To avoid these artifacts, some current methods for MRI may discard the data for an entire scan during which the patient movement occurred, and average the data for the remaining scans prior to MRI image generation.

However, it would be desirable to minimize the amount of data that is discarded during MRI. Some methods using redundant data to replace motion corrupted data are e.g. known from Hangyi Jang et al.: "Origin and minimization of residual motion-related artifacts in navigator-corrected segmented diffusion-weighted EPI of the human brain", Magn. Reson. Med., vol. 47, no. 4, 1 April 2002, pages 818-822; Fernandez-Seara et al: "Correction of Motion Artefacts in High Resolution FSE Images" in Proc. Intl. Soc. Mag. Reson. Med. 11: 2160, 15 May 2004, and US 2015/316635 A1 by Stehning et al.. In addition, certain MRI protocols, such as those applied on neonates, may average only two consecutive scans in order to reduce the imaging time. In such situations, discarding all of the data for one of the two scans might substantially reduce the signal-to-noise ratio and quality of the image. Thus, there is a need for improved systems and methods that generate high quality MRI images, even where a patient undergoing MRI moves during image acquisition.

### SUMMARY

The present invention is defined by the subject-matter of independent claims 1, 6, and 11.

### OUTLINE OF THE DISCLOSURE

In an embodiment, the disclosure describes a computer-implemented method for generating an MRI image of a subject. The computer-implemented method may include performing, using an MRI device, at least two consecutive MRI scans of a subject, a first MRI scan and a second MRI scan. The computer-implemented method may further include obtaining first k-space grid data for the first MRI scan and second k-space grid data for the second MRI scan, comparing the first k-space grid data to the second k-space grid data (e.g., by subtraction on a point by point basis) to obtain delta k-space grid data, and using the delta k-space grid data to determine, on a scan line by scan line basis, if the subject undergoing MRI moved during acquisition of any given scan line either during the first MRI scan or the second MRI scan. If it is determined that the subject moved during acquisition of any given scan line, then the computer-implemented method further includes determining whether the specific scan line movement occurred during the first MRI scan or the second MRI scan using a motion detector. If the movement occurred during the first MRI scan, then the applicable scan line data (i.e., the particular scan line associated with movement) for first k-space grid data is replaced with the same scan line data for the second k-space grid data. Conversely, if the movement occurred during the second MRI scan, then the applicable scan line data for the second k-space grid data is replaced with the same scan line data for the first k-space grid data. The computer-implemented method may further include averaging the resultant first k-space grid data with the resultant second k-space grid and generating an MRI image using the Fourier Transform. By replacing scan line data as described above, the generated MRI image is corrected for motion artifacts.

In another embodiment, the disclosure describes an MRI system that includes an MRI device. The MRI device may include a body defining a bore into which a subject (or portion thereof) is inserted for acquisition of an MRI image, one or more primary magnets configured to generate a primary magnetic field, one or more gradient coils configured to generate gradients of the primary magnetic field, and one or more radiofrequency coils configured to transmit radiofrequency pulses to the subject in the bore of the MRI device and receive radiofrequency signals from the subject in the bore of the MRI device. The MRI system may further include a computer device coupled to the MRI device and including a processor configured according to computer executable instructions. The processor may include an acquisition module configured to cause the MRI device to perform at least two consecutive MRI scans of a subject. The at least two consecutive MRI scans may include a first MRI scan and a second MRI scan. The acquisition module may be further configured to obtain corresponding first k-space grid data and second k-space grid data. The processor may further include a motion correction module in communication with the acquisition module and configured to generate an MRI image in accordance with the computer-implemented method described above.

### BRIEF DESCRIPTION OF THE DRAWINGS

The disclosure may be better understood by reference to the detailed description when considered in conjunction with the accompanying drawings. The components and figures are not necessarily drawn to scale, emphasis being placed instead upon illustrating the principles of the disclosure.
FIG. 1 illustrates a magnetic resonance imaging (MRI) system, according to one embodiment.
FIG. 2 is a schematic representation of a computer device of the MRI system according to one embodiment.
FIG. 3 is a flowchart illustrating a computer-implemented method for MRI motion correction during MRI image acquisition according to one embodiment.
FIG. 4 depicts first exemplary MRI images associated with a first MRI scan (left; original scan0) and a second MRI scan (right; original scan1).
FIG. 5 is an exemplary MRI image generated after averaging the k-space grid data associated with first MRI scan and the second MRI scan of FIG. 4, the MRI image having undesirable motion artifacts.
FIG. 6 is a delta k-space grid data plot resulting from a comparison of the k-space grid data associated with the first MRI scan of FIG. 4 the k-space grid data associated with the second MRI scan of FIG. 4.
FIG. 7 is a plot of standard deviation of delta k-space grid data along each scan line (i.e., row) of the delta k-space grid data plot of FIG. 6.
FIG. 8 is an MRI image of the first MRI scan (scan0) of FIG. 4 after MRI motion correction during MRI image acquisition according to at least one method of the present disclosure.
FIG. 9 is an MRI image associated with the first MRI scan and the second MRI scan of FIG. 5 after averaging corrected k-space grid data according to at least one method of the present disclosure.
FIG. 10 depicts second exemplary MRI images associated with a first MRI scan (left; scan0) and a second MRI scan (right; original scan1).
FIG. 11 is a plot of standard deviation along each scan line (i.e., row) of a delta k-space grid data plot generated using the k-space grid data associated with the first MRI scan of FIG. 10 and the k-space grid data associated with the second MRI scan of FIG. 10.
FIG. 12 depicts third exemplary MRI images associated with a first MRI scan (left; ScanO) and a second MRI scan (right; Scan1).
FIG. 13 depicts the MRI image associated with the first MRI scan of FIG. 12 side-by-side a corrected version of the same after 28 lines of k-space grid data were replaced with corresponding lines from the k-space grid data associated with the second MRI scan of FIG. 12 in accordance with at least one method of the present disclosure.
FIG. 14 depicts an MRI image generated by averaging the k-space grid data associated with the first and second MRI scans of FIG. 12 and having undesirable motion artifacts (left image) and an MRI image generated using the methods of the present disclosure (right image).
FIG. 15 depicts fourth exemplary MRI images associated with a first MRI scan (left; ScanO) and a second MRI scan (right; Scan1).
FIG. 16 depicts the MRI image associated with the second MRI scan of FIG. 15 side-by-side a corrected version of the same after 62 lines off k-space grid data were replaced with corresponding lines from the k-space grid data associated with the first MRI scan of FIG. 15 in accordance with at least one method of the present disclosure.
FIG. 17 depicts an MRI image generated by averaging the k-space grid data associated with the first and second MRI scans of FIG. 15 and having undesirable motion artifacts (left image) and an MRI image generated using the methods of the present disclosure (right image).
FIG. 18 show MRI images corrected for motion artifacts according to methods of the present disclosure with 44% correction (left) and 22% correction (right).
FIG. 19 depicts fifth exemplary MRI images associated with a first MRI scan (left; scan0) and a second MRI scan (right; scan1).
FIG. 20 depicts the MRI image associated with the second MRI scan of FIG. 19 side-by-side a corrected version of the same where lines of k-space grid data were replaced with corresponding lines from the k-space grid data associated with the first MRI scan of FIG. 19 in accordance with at least one method of the present disclosure.
FIG. 21 depicts an MRI image generated by averaging the k-space grid data associated with the first and second MRI scans of FIG. 19 and having undesirable motion artifacts (left image) and an MRI image generated using the methods of the present disclosure (right image).

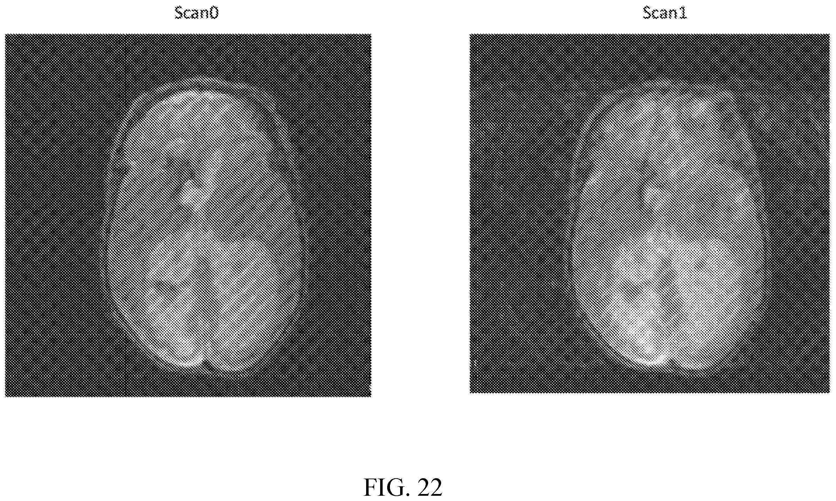

FIG. 22 depicts sixth exemplary MRI images associated with a first MRI scan (left; ScanO) and a second MRI scan (right; Scan1).

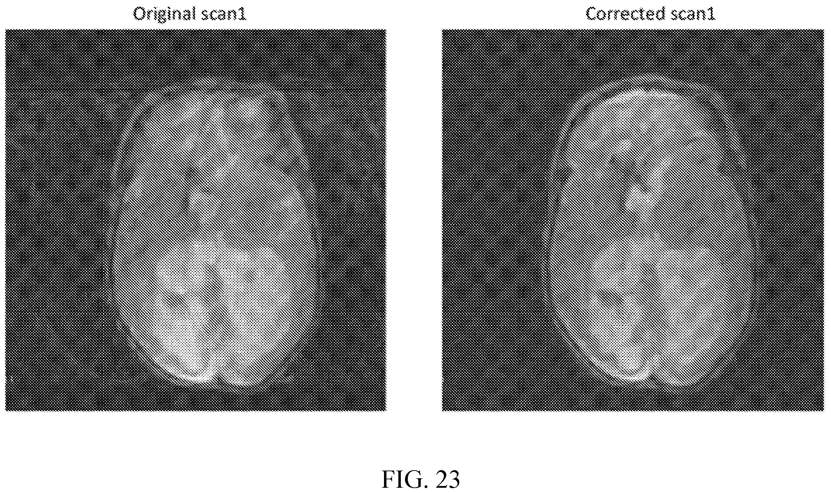

FIG. 23 depicts the MRI image associated with the second MRI scan of FIG 22 side-by-side a corrected version of the same after lines of k-space grid data were replaced with corresponding lines from the k-space grid data associated with the first MRI scan of FIG. 22 in accordance with at least one method of the present disclosure.

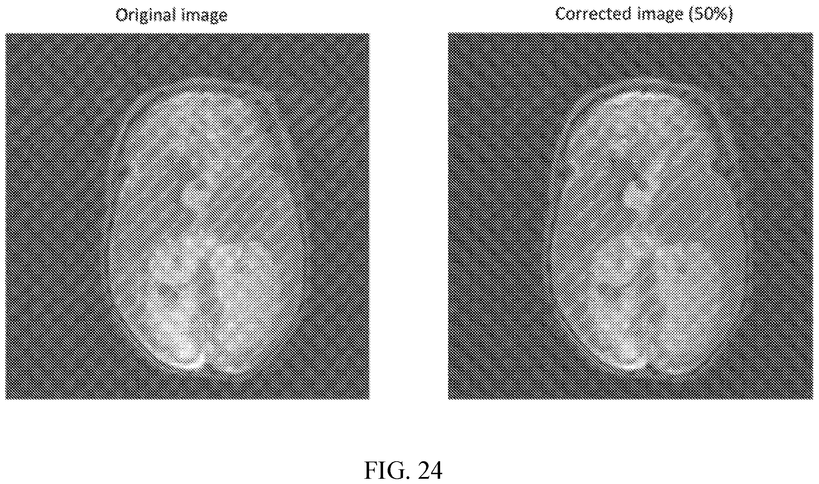

FIG. 24 depicts an MRI image generated by averaging the k-space grid data associated with the first and second MRI scans of FIG. 22 and having undesirable motion artifacts (left image) with an MRI image generated using the methods of the present disclosure (right image)..
FIGS. 25-27 depict MRI images generated by averaging the k-space grid data associated with other exemplary MRI scans (not depicted) and having undesirable motion artifacts (left images) with an MRI image generated using the methods of the present disclosure (right images).

### DETAILED DESCRIPTION

The present description now will be described more fully hereinafter with reference to the accompanying drawings, which form a part hereof, and which show, by way of illustration, specific exemplary embodiments by which the description may be practiced. This description may, however, be embodied in many different forms and should not be construed as limited to the embodiments set forth herein. Rather, these embodiments are provided so that this disclosure will be thorough and complete, and will fully convey the scope of the description to those skilled in the art. The following detailed description is, therefore, not to be taken in a limiting sense.

As used herein, an "MRI image" may be an image generated from data signals collected from one or more MRI scans, and an "MRI scan" may be an MRI pulse sequence used for the collection of the data signals to generate the MRI image. In addition, as used herein, "motion artifacts" may refer to artifacts such as blurring, streaking, or ghosting in the MRI image that result from movement of the subject undergoing MRI scanning.

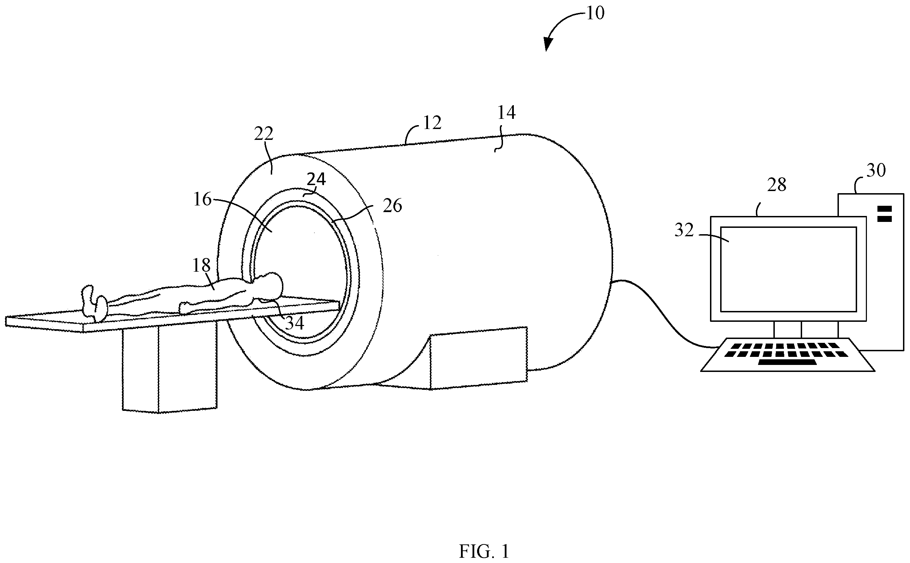

Referring now to the drawings and with specific reference to FIG. 1, an MRI system 10 is shown. The MRI system 10 may include an MRI device 12 having a body 14 defining a bore 16 into which a subject 18 or portion thereof is inserted for an MRI scan. The subject 18 may be a human (adult, child, infant, neonate), an animal, or a non-living object. The MRI device 12 may further include one or more primary magnets 22 configured to generate a primary magnetic field, and one or more gradient coils 24 configured to generate gradients of the primary magnetic field and allow selected slices (e.g., axial, sagittal, coronal) of the subject to be imaged. The one or more primary magnets 22 may be one or more resistive magnets, one or more superconducting magnets or one or more permanent magnets, or any combination thereof, and may have a magnetic field strength ranging from 0.2 to 3.0 Tesla or more. Additionally, the MRI device 12 may include one or more radiofrequency transmitter and receiver coils 26. Any given coil 26 may have both transmit and receive functions, or may be responsible solely for transmit or receive functions. In other words, a coil of the one or more radiofrequency transmitter and receiver coils 26 may be a transmitter coil, a receiver coil or a transceiver coil. The one or more radiofrequency transmitter and receiver coils 26 transmit radiofrequency pulses to the subject 18 and receive radiofrequency signals from the subject 18 during MRI scanning. In some embodiments, the MRI device 12 may be an MRI scanner from Aspect Imaging, Ltd. (Shoham, Israel).

The MRI system 10 may further include a computer device 28 coupled to the MRI device 12 for control thereof. The computer device 28 may include one or more processors 30, at least one non-transitory computer readable medium (e.g., memory) (not illustrated) containing computer-executable instructions stored thereon. The one or more processors 30 may be configured to execute or carry out computer-executable instructions for running a selected MRI protocol (or set of pulse sequences), acquiring k-space grid data, and generating an MRI image, as explained in further detail below. The computer device 28 may also include a display interface 32 allowing an operator to input or alter the MRI protocol, and view the MRI images.

The MRI system 10 may further include a motion sensor 34 in electrical or wireless communication with the computer device 28, and positioned with respect to the subject 18 to detect movement of the subject 18 during acquisition of the MRI image (e.g., during an MRI scan). The motion sensor 34 may be placed proximate a region of interest that is imaged, such as a specific body part. For example, if the head of the subject 18 is imaged, the motion sensor 34 may be placed beneath the head while the image is acquired. In one exemplary embodiment, the motion sensor 34 is a respiration sensor, such as a Graseby Respiration Sensor. The motion sensor 34 may be other types of motion sensors in alternative embodiments.

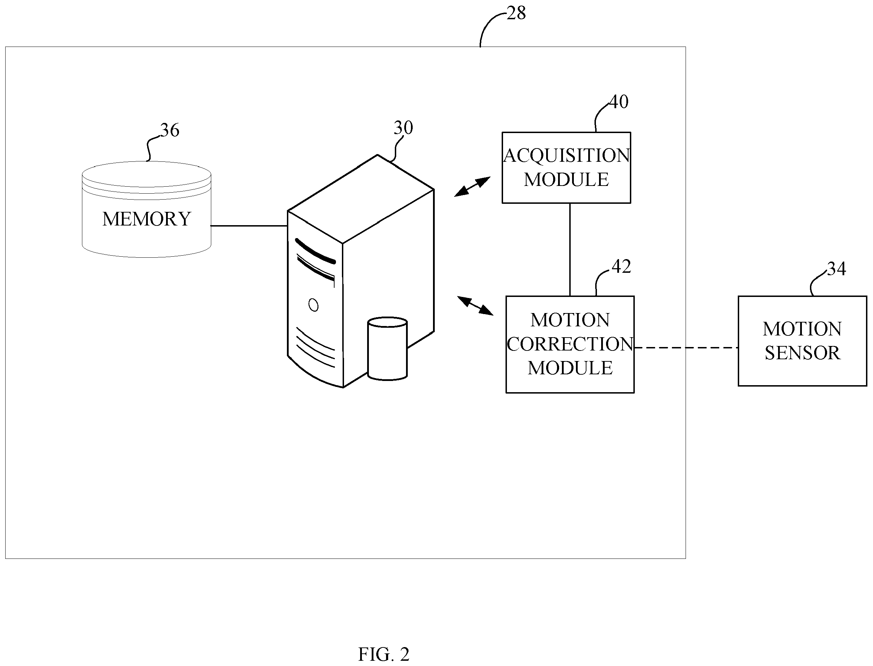

An exemplary computer device 28 of the MRI system 10 is schematically depicted in FIG. 2. The computer device 28 may include the one or more processors 30 configured to execute computer-executable instructions for carrying out various functions such as running a selected MRI protocol, acquiring the MRI image, correcting the MRI image for motion artifacts, and displaying the MRI images at the display interface 32. The computer device 28 may further include memory 36 configured to, among other things, store the computer-executable instructions for execution by processor(s) 30.

The one or more processors 30 may, when executing certain computer readable instructions, operate as an acquisition module 40 that instructs the MRI device 12 to acquire an MRI image according to a selected MRI protocol, and collects MRI image data during acquisition of the MRI image. More specifically, the acquisition module 40 may cause (e.g., control) the MRI device 12 to perform at least two MRI scans (at least a first MRI scan and a second MRI scan) during acquisition of the MRI image of the subject 18. In an embodiment, the first and second MRI scans may be consecutive. Further, the acquisition module 40 may obtain MRI image data in k-space (e.g., that reflect the proton relaxation signals during each of the first and second MRI scans). The k-space data may be obtained scan line by scan line or row by row for each of the first and second MRI scans, thereby generating first k-space grid data and second k-space grid data, respectively.

The processor(s) 30 may further, when executing certain other computer readable instructions, operate as a motion correction module 42 in communication with the acquisition module 40 and motion sensor 34 for collection of data therefrom. As explained more specifically below, the motion correction module 42 collects the data from the acquisition module 40 and data from the motion sensor 34, and provides MRI motion correction during MRI image acquisition.

In one embodiment, acquisition module 40 and motion correction module 42 may be implemented as any other single or collection of circuit(s), integrated circuit(s), processor(s), processing device(s), transistor(s), memory(s), storage(s), computer readable medium(s), combination logic circuit(s), or any combination of the above that is capable of providing a desired operation(s) or function(s). "Memory," "computer-readable media," and "storage" may refer to any suitable internal or external volatile or non-volatile, memory device, memory chip(s), or storage device or chip(s) such as, but not limited to system memory, frame buffer memory, flash memory, random access memory (RAM), read only memory (ROM), a register, a latch, or any combination of the above. A "processor" may refer to one or more dedicated or non-dedicated: micro-processors, micro-controllers, sequencers, micro-sequencers, digital signal processors, processing engines, hardware accelerators, applications specific circuits (ASICs), state machines, programmable logic arrays, any integrated circuit(s), discreet circuit(s), etc. that is/are capable of processing data or information, or any suitable combination(s) thereof. "Executable instructions" may refer to software, firmware, programs, instructions or any other suitable instructions or commands capable of being processed by a suitable processor.

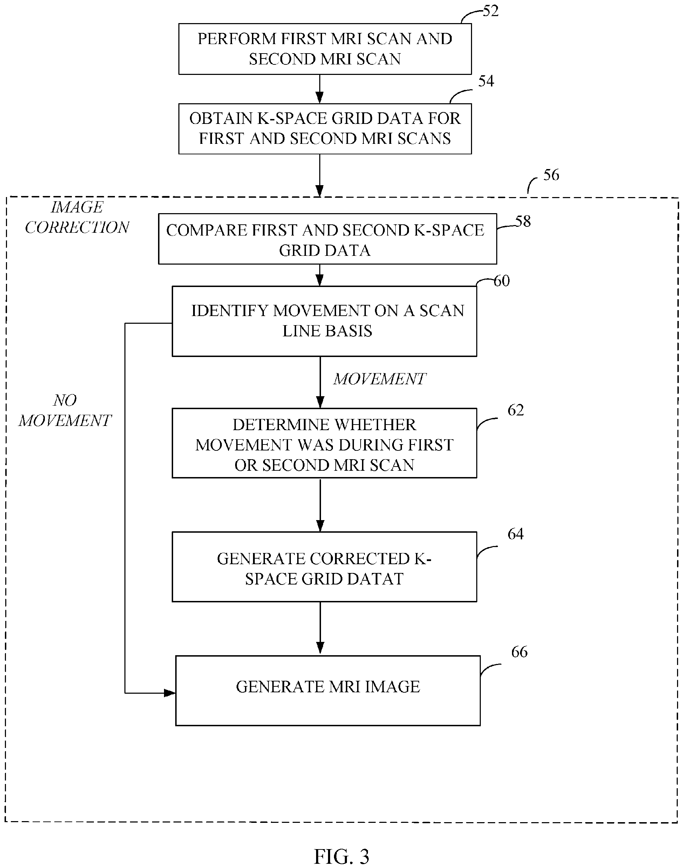

A method for acquiring an MRI image and providing MRI motion correction during MRI image acquisition, as performed by the one or more processors 30 of the computer device 28 is illustrated in FIG. 3. The method may begin with acquisition of an MRI image after the subject 18 or portion thereof is inserted into the bore 16 of the MRI device 12. During the acquisition of the MRI image, at least two MRI scans (a first MRI scan and a second MRI scan) are performed using a selected MRI protocol (block 52). First and second MRI scans may be consecutive scans. Data (e.g., associated with T1 and T2 relaxation of the subject's protons) are collected in k-space for each of the first and second MRI scans, according to block 54, thereby generating first and second k-space grid data, respectively. K-space grid data may be collected row by row for each scan.

After block 54, an MRI motion correction method 56 is applied. In one embodiment, the image correction method 56 is performed by the motion correction module 42 upon receipt of the first and second k-space grid data from the acquisition module 40. At block 58 of the image correction method 56, the first k-space grid data and second k-space grid data is compared (e.g., point by point via subtraction) to generate a delta k-space grid data where each point represents the difference between corresponding points in the first k-space grid data and the second k-space grid data. The method then, based on the delta k-space grid data, determines whether the subject undergoing MRI moved during acquisition of any given scan line in either the first or second MRI scan, at block 60. In one example, the method makes such determination by determining the standard deviation of the values of any given row of the delta k-space grid data. If the standard deviation for any row in the delta k-space grid data is greater than a threshold value, then it is determined that there was movement of the subject during acquisition of that scan line in either the first or second MRI scan. Notably, the identification of one or more rows having a standard deviation above the threshold may indicate movement of the subject occurred during acquisition of the data in that row, but may not provide information as to whether the movement occurred during acquisition of the row number in the first MRI scan or the second MRI scan. The threshold may be predetermined and chosen by the operator of the MRI device 12, or may be a default value that varies depending on the pulse sequence.

If at least one of the row numbers in the k-space subtraction has a standard deviation above the threshold indicating movement of the subject occurred, the MRI image is "corrected" for motion artifacts according to the following description. At block 62, it is determined whether the specific movement of the subject 18 occurred during the first MRI scan or the second MRI scan based on data collected from the motion sensor 34. Specifically, block 62 may involve determining a time of the movement based on data collected from the motion sensor 34, and determining whether the time of the movement occurred during acquisition of the specific scan line where movement was determined to have occurred. If the movement occurred during the first MRI scan, then the applicable scan line data for the first k-space grid data associated with movement is replaced with the same scan line data from the second k-space grid data to "correct" the data of the first MRI scan (block 64). Conversely, if the movement occurred during the second MRI scan, then the applicable scan line data for the second k-space grid data associated with movement is replaced with the same scan line data from the first k-space grid data, Such replacement may be performed for each scan line of the delta k-space grid data having a standard deviation above the threshold. An MRI image is then generated at block 66. Block 66 may include averaging corrected first k-space grid data and/or corrected second k-space grid data and performing a Fourier Transition on the averaged data to generate an MRI image from the first and second MRI scans.

If none of the row numbers have a standard deviation above the threshold indicating that the subject did not move during either of the first or second MRI scans, then the MRI image can be generated (block 66), using for example the first and second k-space grid data. It will be understood that the image correction method 56 described above may be adapted for image correction when more than two MRI scans are performed. For instance, the image correction method 56 may involve repeating the method as additional k-space grid data are collected with each additional scan.

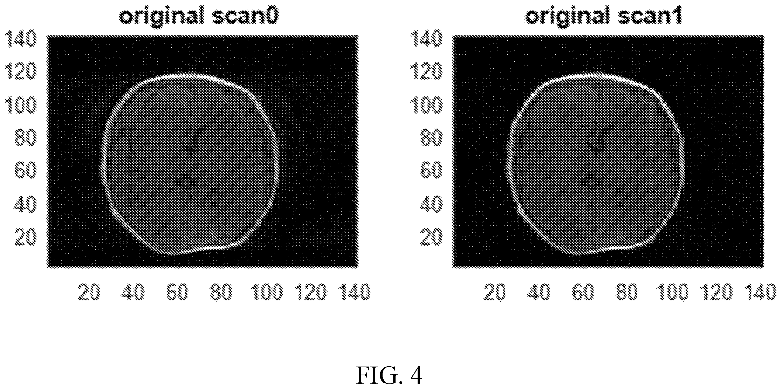

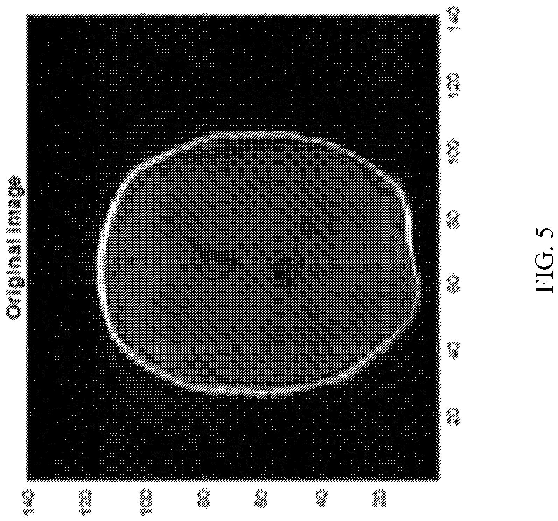

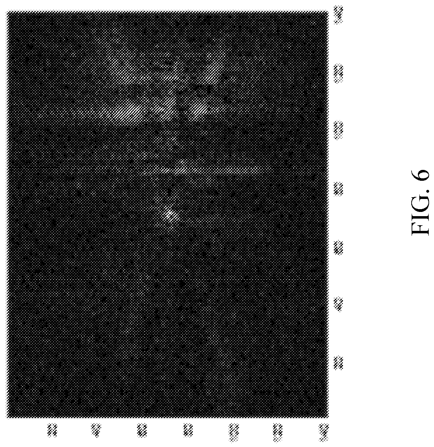

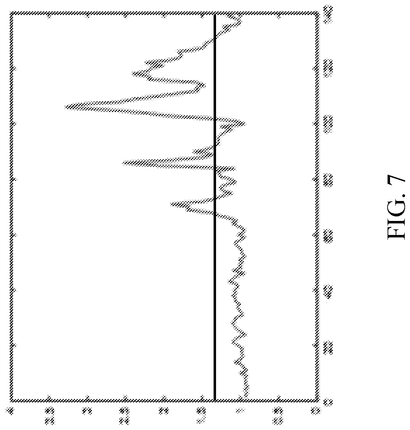

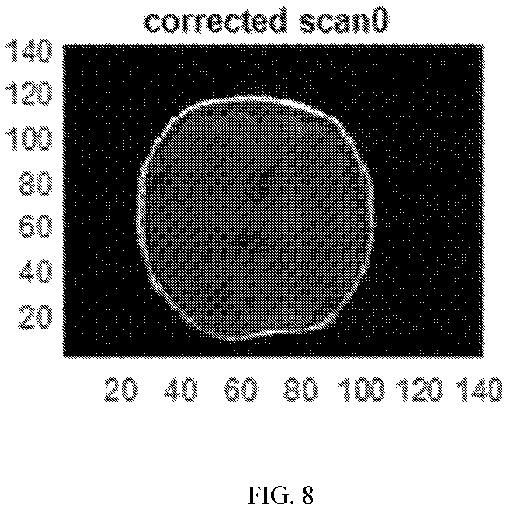

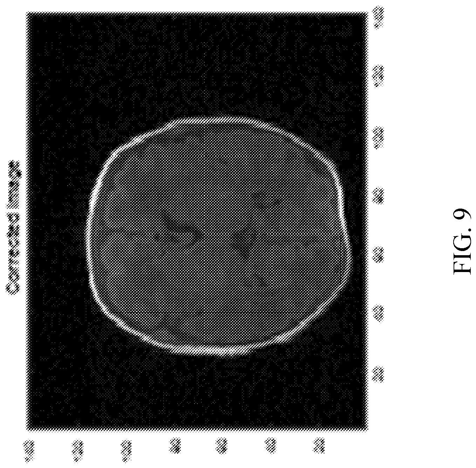

FIGs. 4-8 illustrate an example of an implementation of the image correction method 56 described above. FIG. 4 depicts first exemplary MRI images associated with a first MRI scan (left; original scan0) and a second MRI scan (right; original scan1). The k-space grid data associated with each of these images can be averaged to generate the MRI image depicted in FIG. 5. As one of skill in the art will recognize, the MRI image of FIG. 5 includes undesirable motion artifacts. FIG. 6 is a delta k-space grid data plot resulting from a comparison of the k-space grid data associated with the first MRI scan of FIG. 4 and the k-space grid data associated with the second MRI scan of FIG. 4. FIG. 7 is a plot of the standard deviation of the delta k-space grid data along each scan line (i.e., row) of the delta k-space grid data plot of FIG. 6. Peaks in the plot above an exemplary threshold 80 indicate that unacceptable or undesirable amount of movement of the subject 18 occurred during acquisition of the data signals for those scan lines/rows. In FIG. 7, 45 scan lines/rows have a standard deviation above threshold 80, indicating that unacceptable/undesirable movement of the subject occurred during acquisition of the data signals for each of those scan lines/rows. If it is determined that each movement occurred during the first MRI scan based on the data received from the motion sensor 34, then the scan lines in the first k-space grid data associated with each of the 45 scan lines having a standard deviation over the threshold are replaced with corresponding scan lines in the second k-space grid data, and following a Fourier Transform, an exemplary resultant image associated with the corrected first k-space grid data is depicted in FIG. 8. FIG. 9 depicts an exemplary MRI image generated after averaging the corrected first k-space grid data with the second k-space grid data.

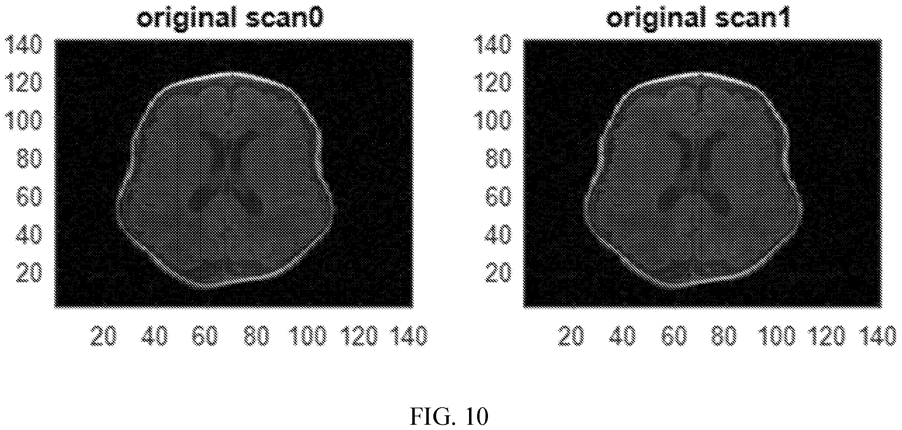

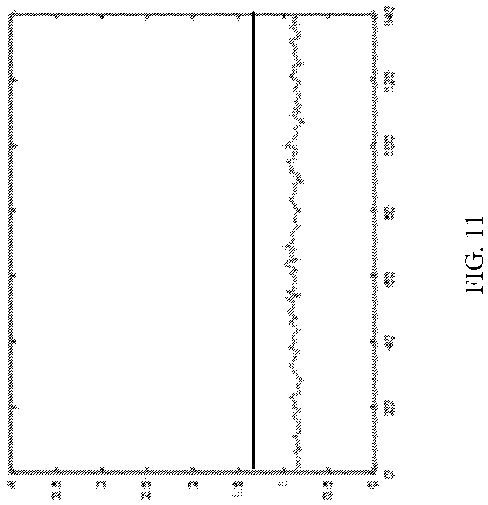

For comparison, FIG. 10 depicts second exemplary MRI images associated with a first MRI scan (left; scan0) and a second MRI scan (right; original scan1). And FIG. 11 indicates that there is no unacceptable movement because none of the peaks in the standard deviation plot are above the threshold.

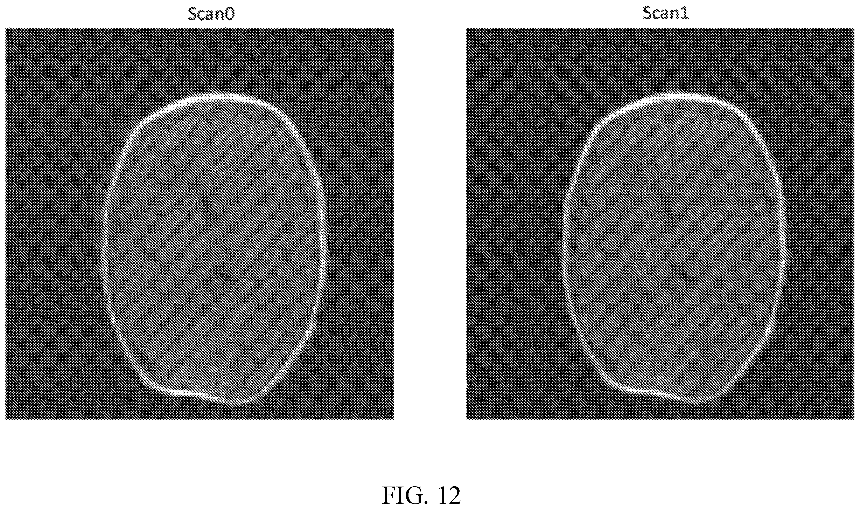

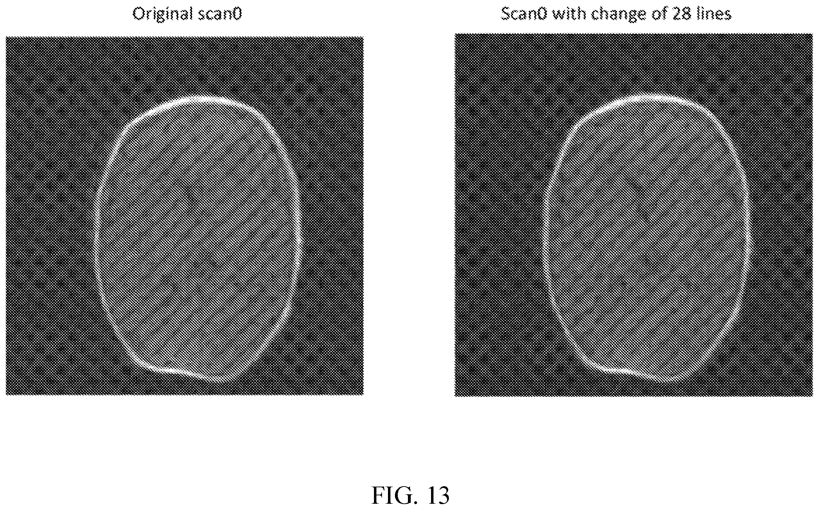

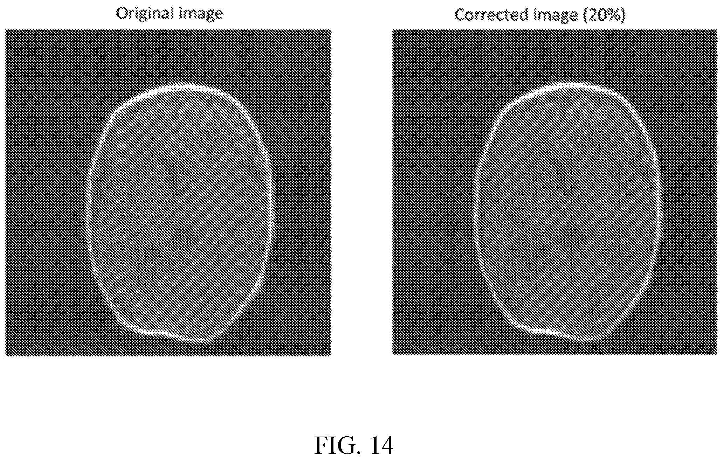

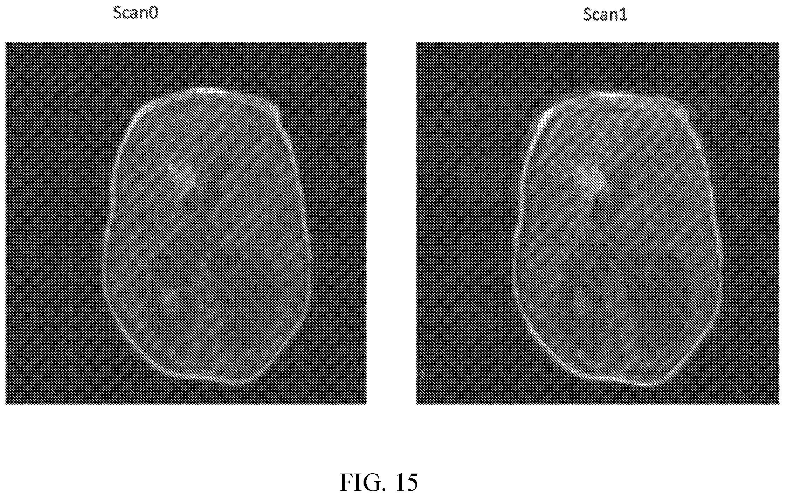

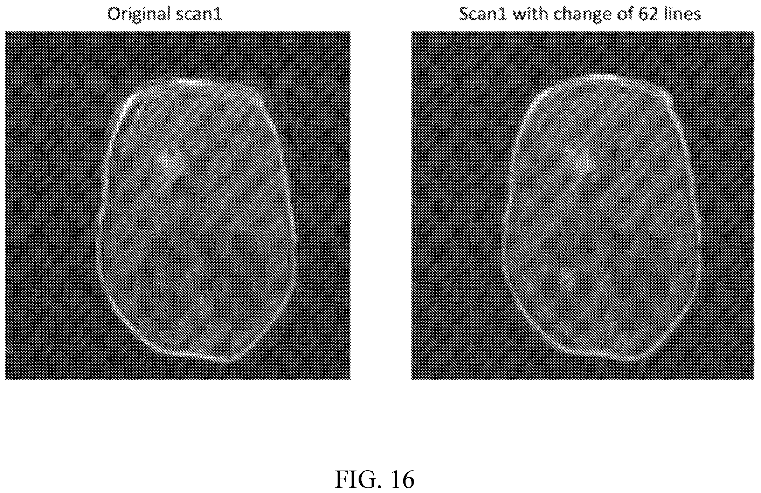

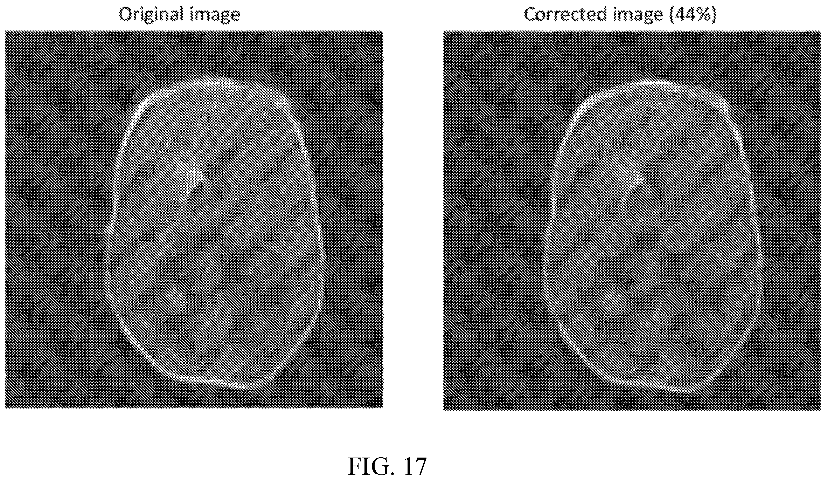

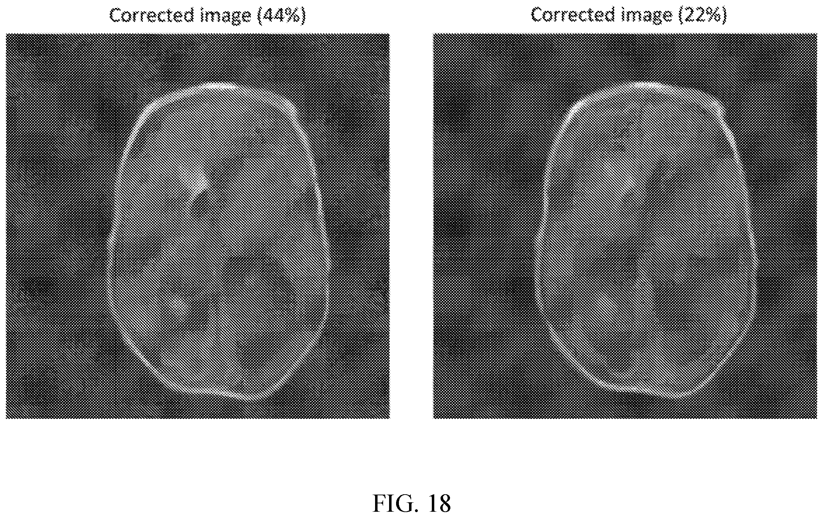

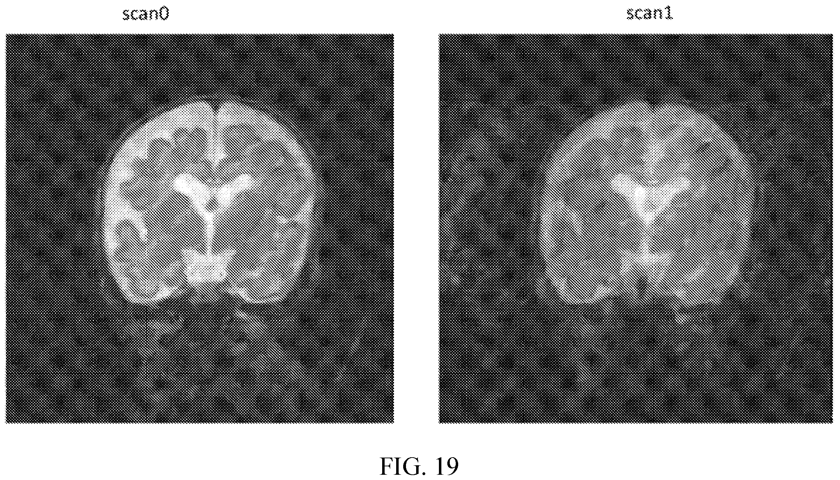

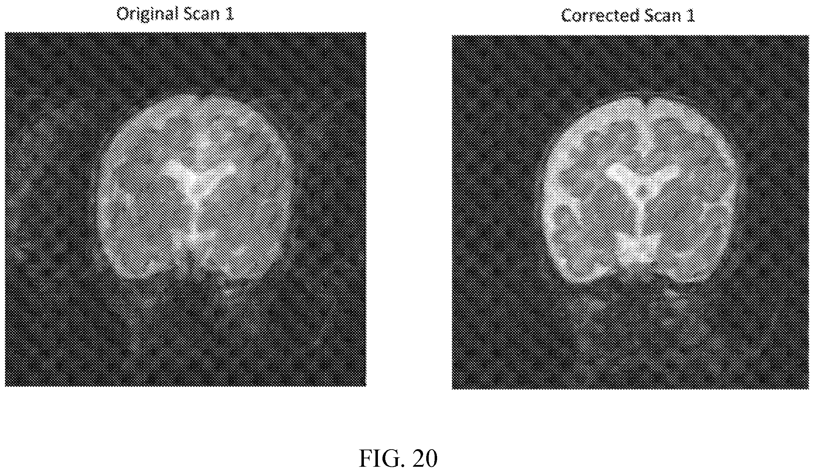

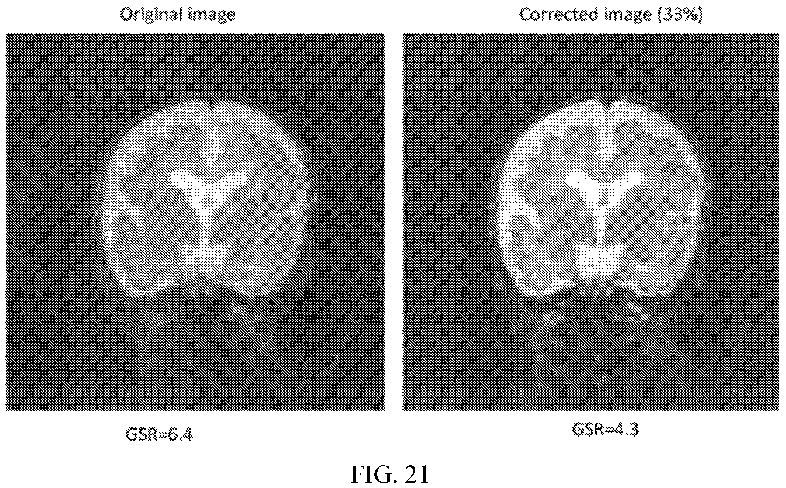

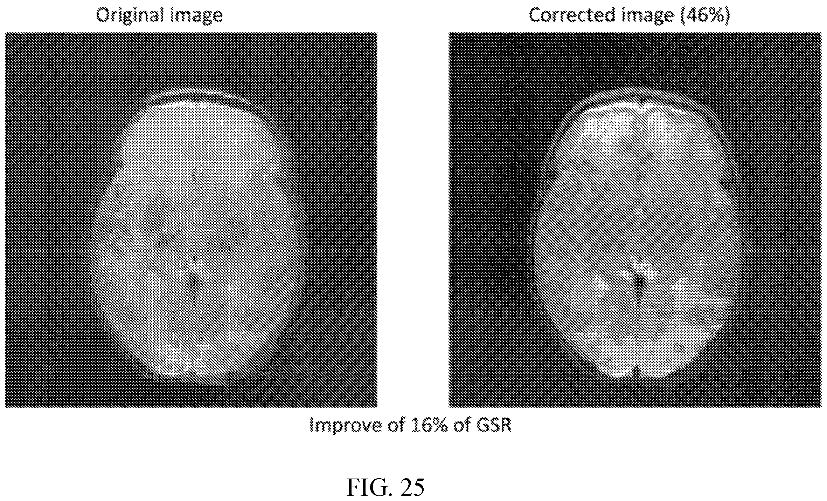

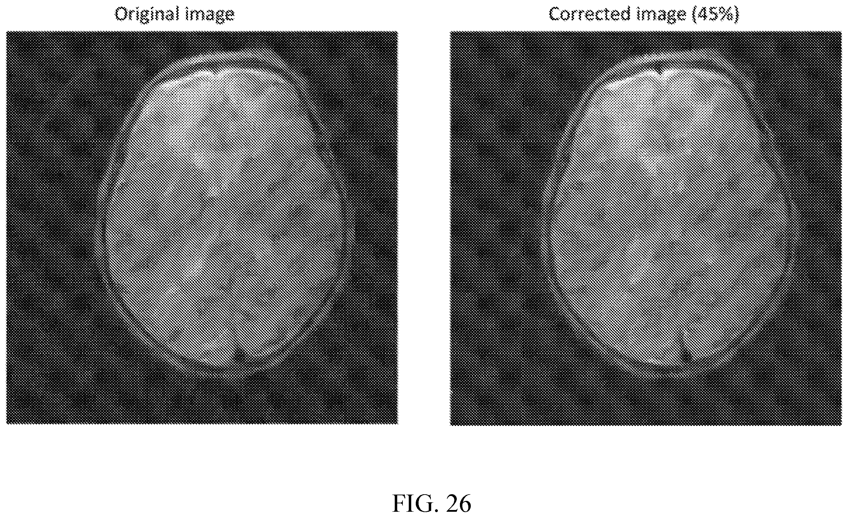

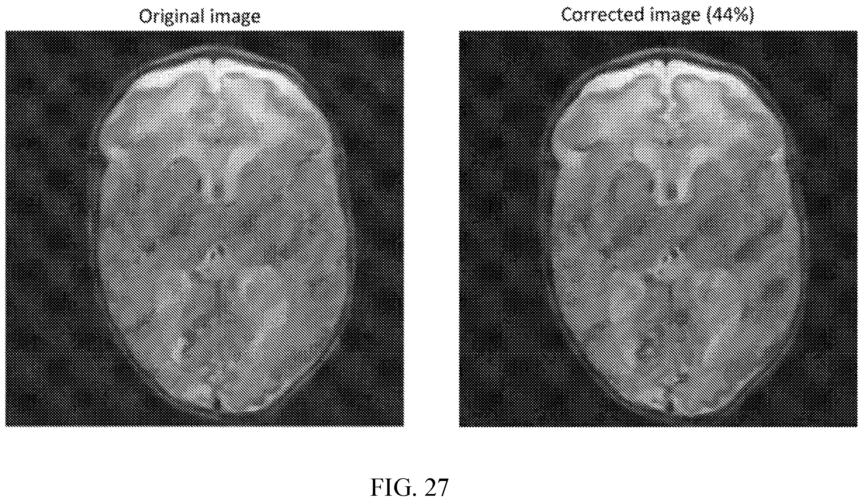

FIGS. 12-21 depict similar MRI images where all of the movement occurred during the first MRI scan in the case of FIG. 12-14 and the second MRI scan in the case of FIG.15-21. Like FIG. 9, FIGS. 14, 17-18, 25, and 28 depict "corrected" MRI images generated by averaging the corrected k-space grid data following one or more scan line replacements. FIGS. 25-27 depict other exemplary MRI images generated by averaging the k-space grid data associated with other exemplary MRI scans (not depicted) and having undesirable motion artifacts (left images) with an MRI image generated using the methods of the present disclosure (right images).
As a result of the system and method described herein, a technical problem of retaining meaningful MRI scan data is addressed. By replacing only scan lines in k-space associated with movement, the present system and method improves computers and processors controlling MRI systems and improves signal to noise and image quality.

## Claims

1. A computer-implemented method for generating a magnetic resonance imaging (MRI) image of a subject (18) using an MRI device (12) comprising:
obtaining (54) first k-space grid data associated with a first MRI scan and second k-space grid data associated with a second MRI scan;
identifying (58,60), based on the first and second k-space grid data, at least one instance of subject movement during acquisition of scan line data for the first or second k-space grid data as part of one or more of the first MRI scan and the second MRI scan;
determining (62), using a motion sensor (34), for each identified instance of subject movement whether the subject movement was during the first MRI scan or the second MRI scan;
generating (64) at least one of: corrected first k-space grid data using second k-space grid data and corrected second k-space grid data using first k-space grid data; and
generating (66) an MRI image based on one of: the corrected first k-space data and second k-space data; the corrected first k-space data and the corrected second k-space data; and the first k-space data and the corrected second k-space data.

2. The computer-implemented method of claim 1 , wherein the first MRI scan and the second MRI scan are consecutive.

3. The computer-implemented method of claim 1, wherein the identifying, based on the first and second k-space grid data, at least one instance of subject movement during acquisition of scan line data for the first or second k-space grid data as part of one or more of the first MRI scan and the second MRI scan comprises:
generating a delta k-space grid data where each point represents a difference between corresponding points in the first k-space grid data and the second k-space grid data; for each row of the delta k-space grid data, determining a standard deviation value based on the data in each such row; and
identifying those rows of the delta k-space grid data where the applicable standard deviation value is greater than a threshold.

4. The computer-implemented method of claim 1, wherein:
generating corrected first k-space grid data using second k-space grid data comprises replacing a scan line of the first k-space grid with a corresponding scan line in the second k-space grid if the subject movement was during the first MRI scan; and
generating corrected second k-space grid data using first k-space grid data comprises replacing a scan line of the second k-space grid with a corresponding scan line in the first k-space grid if the subject movement was during the second MRI scan.

5. The computer-implemented method of claim 1, wherein generating an MRI image comprises one of:
averaging the corrected first k-space data and second k-space data;
averaging the corrected first k-space data and the corrected second k-space data; and
averaging the first k-space data and the corrected second k-space data.

6. A magnetic resonance imaging (MRI) system, comprising:
an MRI device (12) including a body (14) defining a bore (16) configured such that a subject or a portion thereof is inserted for acquisition of an MRI image using a first MRI scan and a second MRI scan; and
an acquisition module (40) configured to obtain first k-space grid data associated with the first MRI scan and second k-space grid data associated with the second MRI scan; and a motion sensor configured to detect movement of the subject; and
a motion correction module (42) configured to:
identify (58,60), based on the first and second k-space grid data, at least one instance of subject movement during acquisition of scan line data for the first or second k-space grid data as part of one or more of the first MRI scan and the second MRI scan;
determine (62), using the sr motion sensor (34), for each identified instance of subject movement whether the subject movement was during the first MRI scan or the second MRI scan;
generate (64) at least one of: corrected first k-space grid data using second k-space grid data and corrected second k-space grid data using first k-space grid data; and
generate (66) an MRI image based on one of: the corrected first k-space data and second k-space data; the corrected first k-space data and the corrected second k-space data; and the first k-space data and the corrected second k-space data.

7. The MRI system of claim 6, wherein the first MRI scan and the second MRI scan are consecutive.

8. The MRI system of claim 6, wherein the motion correction module (42) is further configured to:
generate a delta k-space grid data where each point represents a difference between corresponding points in the first k-space grid data and the second k-space grid data;
for each row of the delta k-space grid data, determine a standard deviation value based on the data in each such row; and
identify those rows of the delta k-space grid data where the applicable standard deviation value is greater than a threshold.

9. The MRI system of claim 6, wherein the motion correction module is further configured to:
generate corrected first k-space grid data using second k-space grid data by replacing a scan line of the first k-space grid with a corresponding scan line in the second k-space grid if the subject movement was during the first MRI scan; and
generate corrected second k-space grid data using first k-space grid data by replacing a scan line of the second k-space grid with a corresponding scan line in the first k-space grid if the subject movement was during the second MRI scan.

10. The MRI system of claim 6, wherein the motion correction module is further configured to generate an MRI image by one of:
averaging the corrected first k-space data and second k-space data;
averaging the corrected first k-space data and the corrected second k-space data; and
averaging the first k-space data and the corrected second k-space data.

11. A non-transitory computer readable medium comprising instructions to cause the MRI system of claim 6 to execute the steps of the method of claim 1.

12. The non-transitory computer readable medium of claim 11, wherein the first MRI scan and the second MRI scan are consecutive.

13. The non-transitory computer readable medium of claim 11, wherein the instructions further cause the motion correction module (42) to identify, based on the first and second k-space grid data, at least one instance of subject movement during acquisition of scan line data for the first or second k-space grid data as part of one or more of the first MRI scan and the second MRI scan by:
generating a delta k-space grid data where each point represents a difference between corresponding points in the first k-space grid data and the second k-space grid data;
for each row of the delta k-space grid data, determining a standard deviation value based on the data in each such row; and
identifying those rows of the delta k-space grid data where the applicable standard deviation value is greater than a threshold.

14. The non-transitory computer readable medium of claim 11 wherein the instructions further cause the motion correction module (42) to:
generate corrected first k-space grid data using second k-space grid data by replacing a scan line of the first k-space grid with a corresponding scan line in the second k-space grid if the subject movement was during the first MRI scan; and
generate corrected second k-space grid data using first k-space grid data by a scan line of the second k-space grid with a corresponding scan line in the first k-space grid if the subject movement was during the second MRI scan.

15. The non-transitory computer readable medium of claim 11 wherein the instructions further cause the motion correction module (42) to average one of: the corrected first k-space data and second k-space data; the corrected first k-space data and the corrected second k-space data; and the first k-space data and the corrected second k-space data.

## Patentansprüche

1. Computerimplementiertes Verfahren zum Erzeugen eines Magnetresonanztomographie-Bildes (MRT-Bildes) eines Subjekts (18) unter Verwendung einer MRT-Vorrichtung (12), umfassend:
Erhalten (54) von ersten k-Raum-Rasterdaten, die mit einem ersten MRT-Scan verknüpft sind, und zweiten k-Raum-Rasterdaten, die mit einem zweiten MRT-Scan verknüpft sind;
Identifizieren (58, 60), basierend auf den ersten und zweiten k-Raum-Rasterdaten, von mindestens einem Fall einer Subjektbewegung während einer Erfassung von Scanliniendaten für die ersten oder zweiten k-Raum-Rasterdaten als Teil eines oder mehrerer des ersten MRT-Scans und des zweiten MRT-Scans;
Bestimmen (62), unter Verwendung eines Bewegungssensors (34), für jeden identifizierten Fall einer Subjektbewegung, ob die Subjektbewegung während des ersten MRT-Scans oder des zweiten MRT-Scans stattfand;
Erzeugen (64) von mindestens einem von: korrigierten ersten k-Raum-Rasterdaten unter Verwendung von zweiten k-Raum-Rasterdaten und korrigierten zweiten k-Raum-Rasterdaten unter Verwendung von ersten k-Raum-Rasterdaten; und
Erzeugen (66) eines MRT-Bildes basierend auf einem von: den korrigierten ersten k-Raum-Daten und den zweiten k-Raum-Daten; den korrigierten ersten k-Raum-Daten und den korrigierten zweiten k-Raum-Daten; und den ersten k-Raum-Daten und den korrigierten zweiten k-Raum-Daten.

2. Computerimplementiertes Verfahren nach Anspruch 1, wobei der erste MRT-Scan und der zweite MRT-Scan aufeinander folgen.

3. Computerimplementiertes Verfahren nach Anspruch 1, wobei das Identifizieren, basierend auf den ersten und zweiten k-Raum-Rasterdaten, von mindestens einem Fall der Subjektbewegung während der Erfassung von Scanliniendaten für die ersten oder zweiten k-Raum-Rasterdaten als Teil eines oder mehrerer des ersten MRT-Scans und des zweiten MRT-Scans umfasst:
Erzeugen von Delta-k-Raum-Rasterdaten, wobei jeder Punkt eine Differenz zwischen entsprechenden Punkten in den ersten k-Raum-Rasterdaten und den zweiten k-Raum-Rasterdaten darstellt; für jede Zeile der Delta-k-Raum-Rasterdaten, Bestimmen eines Standardabweichungswerts basierend auf den Daten in jeder derartigen Zeile; und
Identifizieren dieser Zeilen der Delta-k-Raum-Rasterdaten, bei denen der anwendbare Standardabweichungswert größer als ein Schwellenwert ist.

4. Computerimplementiertes Verfahren nach Anspruch 1, wobei:
das Erzeugen von korrigierten ersten k-Raum-Rasterdaten unter Verwendung von zweiten k-Raum-Rasterdaten ein Ersetzen einer Scanlinie des ersten k-Raum-Rasters durch eine entsprechende Scanlinie in dem zweiten k-Raum-Raster, falls die Subjektbewegung während des ersten MRT-Scans stattfand, umfasst; und
das Erzeugen von korrigierten zweiten k-Raum-Rasterdaten unter Verwendung von ersten k-Raum-Rasterdaten das Ersetzen einer Scanlinie des zweiten k-Raum-Rasters durch eine entsprechende Scanlinie in dem ersten k-Raum-Raster, falls die Subjektbewegung während des zweiten MRT-Scans stattfand, umfasst.

5. Computerimplementierte Verfahren nach Anspruch 1, wobei das Erzeugen eines MRT-Bildes eines umfasst von:
Mitteln der korrigierten ersten k-Raum-Daten und zweiten k-Raum-Daten;
Mitteln der korrigierten ersten k-Raum-Daten und der korrigierten zweiten k-Raum-Daten; und
Mitteln der ersten k-Raum-Daten und der korrigierten zweiten k-Raum-Daten.

6. Magnetresonanztomographiesystem (MRT-System), umfassend:
eine MRT-Vorrichtung (12), die einen Körper (14) einschließt, der eine Bohrung (16) definiert, die derart konfiguriert ist, dass ein Subjekt oder ein Abschnitt davon für die Erfassung eines MRT-Bildes unter Verwendung eines ersten MRT-Scans und eines zweiten MRT-Scans eingeführt wird; und
ein Erfassungsmodul (40), das konfiguriert ist, um erste k-Raum-Rasterdaten, die mit dem ersten MRT-Scan verknüpft sind, und zweite k-Raum-Rasterdaten, die mit dem zweiten MRT-Scan verknüpft sind, zu erfassen; und
einen Bewegungssensor, der konfiguriert ist, um die Bewegung des Subjekts zu erkennen; und
ein Bewegungskorrekturmodul (42), das konfiguriert ist zum:
Identifizieren (58, 60), basierend auf den ersten und zweiten k-Raum-Rasterdaten, von mindestens einem Fall einer Subjektbewegung während der Erfassung von Scanliniendaten für die ersten oder zweiten k-Raum-Rasterdaten als Teil eines oder mehrerer des ersten MRT-Scans und des zweiten MRT-Scans;
Bestimmen (62), unter Verwendung des Bewegungssensors (34), für jeden identifizierten Fall einer Subjektbewegung, ob die Subjektbewegung während des ersten MRT-Scans oder des zweiten MRT-Scans stattfand;
Erzeugen (64) von mindestens einem von: korrigierten ersten k-Raum-Rasterdaten unter Verwendung von zweiten k-Raum-Rasterdaten und korrigierten zweiten k-Raum-Rasterdaten unter Verwendung von ersten k-Raum-Rasterdaten; und
Erzeugen (66) eines MRT-Bildes basierend auf einem von: den korrigierten ersten k-Raum-Daten und den zweiten k-Raum-Daten; den korrigierten ersten k-Raum-Daten und den korrigierten zweiten k-Raum-Daten; und den ersten k-Raum-Daten und den korrigierten zweiten k-Raum-Daten.

7. MRT-System nach Anspruch 6, wobei der erste MRT-Scan und der zweite MRT-Scan aufeinander folgen.

8. MRT-System nach Anspruch 6, wobei das Bewegungskorrekturmodul (42) ferner konfiguriert ist zum:
Erzeugen von Delta-k-Raum-Rasterdaten, wobei jeder Punkt eine Differenz zwischen entsprechenden Punkten in den ersten k-Raum-Rasterdaten und den zweiten k-Raum-Rasterdaten darstellt;
für jede Zeile der Delta-k-Raum-Rasterdaten, Bestimmen eines Standardabweichungswerts basierend auf den Daten in jeder derartigen Zeile; und
Identifizieren dieser Zeilen der Delta-k-Raum-Rasterdaten, bei denen der anwendbare Standardabweichungswert größer als ein Schwellenwert ist.

9. MRT-System nach Anspruch 6, wobei das Bewegungskorrekturmodul ferner konfiguriert ist zum:
Erzeugen von korrigierten ersten k-Raum-Rasterdaten unter Verwendung von zweiten k-Raum-Rasterdaten durch Ersetzen einer Scanlinie des ersten k-Raum-Rasters durch eine entsprechende Scanlinie in dem zweiten k-Raum-Raster, falls die Subjektbewegung während des ersten MRT-Scans stattfand, umfasst; und
Erzeugen von korrigierten zweiten k-Raum-Rasterdaten unter Verwendung von ersten k-Raum-Rasterdaten durch Ersetzen einer Scanlinie des zweiten k-Raum-Rasters durch eine entsprechende Scanlinie in dem ersten k-Raum-Raster, falls die Subjektbewegung während des zweiten MRT-Scans stattfand, umfasst.

10. MRT-System nach Anspruch 6, wobei das Bewegungskorrekturmodul ferner konfiguriert ist, um ein MRT-Bild zu erzeugen durch eines von:
Mitteln der korrigierten ersten k-Raum-Daten und zweiten k-Raum-Daten;
Mitteln der korrigierten ersten k-Raum-Daten und der korrigierten zweiten k-Raum-Daten; und
Mitteln der ersten k-Raum-Daten und der korrigierten zweiten k-Raum-Daten.

11. Nichtflüchtiges computerlesbares Medium,
umfassend Anweisungen, um das MRT-System von Anspruch 6 zu veranlassen, die Schritte des Verfahrens von Anspruch 1 auszuführen.

12. Nichtflüchtiges, computerlesbares Medium nach Anspruch 11, wobei der erste MRT-Scan und der zweite MRT-Scan aufeinander folgen.

13. Nichtflüchtiges, computerlesbares Medium nach Anspruch 11, wobei die Anweisungen das Bewegungskorrekturmodul (42) ferner veranlassen, basierend auf den ersten und zweiten k-Raum-Rasterdaten, mindestens einen Fall der Subjektbewegung während der Erfassung von Scanliniendaten für die ersten oder zweiten k-Raum-Rasterdaten als Teil eines oder mehrerer des ersten MRT-Scans und des zweiten MRT-Scans zu identifizieren durch:
Erzeugen von Delta-k-Raum-Rasterdaten, wobei jeder Punkt eine Differenz zwischen entsprechenden Punkten in den ersten k-Raum-Rasterdaten und den zweiten k-Raum-Rasterdaten darstellt;
für jede Zeile der Delta-k-Raum-Rasterdaten, Bestimmen eines Standardabweichungswerts basierend auf den Daten in jeder derartigen Zeile; und
Identifizieren dieser Zeilen der Delta-k-Raum-Rasterdaten, bei denen der anwendbare Standardabweichungswert größer als ein Schwellenwert ist.

14. Nichtflüchtiges, computerlesbare Medium nach Anspruch 11, wobei die Anweisungen das Bewegungskorrekturmodul (42) ferner veranlassen zum:
Erzeugen von korrigierten ersten k-Raum-Rasterdaten unter Verwendung von zweiten k-Raum-Rasterdaten durch Ersetzen einer Scanlinie des ersten k-Raum-Rasters durch eine entsprechende Scanlinie in dem zweiten k-Raum-Raster, falls die Subjektbewegung während des ersten MRT-Scans stattfand, umfasst; und
Erzeugen von korrigierten zweiten k-Raum-Rasterdaten unter Verwendung von ersten k-Raum-Rasterdaten durch eine Scanlinie des zweiten k-Raum-Rasters durch eine entsprechende Scanlinie in dem ersten k-Raum-Raster, falls die Subjektbewegung während des zweiten MRT-Scans stattfand, umfasst.

15. Nichtflüchtiges, computerlesbares Medium nach Anspruch 11, wobei die Anweisungen das Bewegungskorrekturmodul (42) ferner veranlassen, eines zu mitteln von:
den korrigierten ersten k-Raum-Daten und zweiten k-Raum-Daten;
den korrigierten ersten k-Raum-Daten und den korrigierten zweiten k-Raum-Daten;
und den ersten k-Raum-Daten und den korrigierten zweiten k-Raum-Daten.

## Revendications

1. Procédé mis en oeuvre par ordinateur permettant de générer une image d'imagerie par résonance magnétique (IRM) d'un sujet (18) à l'aide d'un appareil d'IRM (12) comprenant :
l'obtention (54) de premières données de grille d'espace k associées à un premier balayage d'IRM et de secondes données de grille d'espace k associées à un second balayage d'IRM ;
l'identification (58,60), sur la base des premières et secondes données de grille d'espace k, d'au moins un cas de déplacement du sujet pendant l'acquisition des données de ligne de balayage pour les premières ou secondes données de grille d'espace k dans le cadre d'un ou plusieurs du premier balayage d'IRM et du second balayage d'IRM ;
le fait de déterminer (62), à l'aide d'un capteur de mouvement (34), pour chaque cas identifié de déplacement du sujet, si le déplacement du sujet s'est produit pendant le premier balayage d'IRM ou le second balayage d'IRM ;
la génération (64) d'au moins l'une parmi : les premières données de grille d'espace k corrigées à l'aide des secondes données de grille d'espace k et les secondes données de grille d'espace k corrigées à l'aide des premières données de grille d'espace k ; et
la génération (66) d'une image IRM basée sur l'une parmi : les premières données d'espace k corrigées et les secondes données d'espace k ; les premières données d'espace k corrigées et les secondes données d'espace k corrigées ; et les premières données d'espace k et les secondes données d'espace k corrigées.

2. Procédé mis en oeuvre par ordinateur selon la revendication 1, dans lequel le premier balayage d'IRM et le second balayage d'IRM sont consécutifs.

3. Procédé mis en oeuvre par ordinateur selon la revendication 1, dans lequel l'identification, sur la base des premières et secondes données de grille d'espace k, d'au moins un cas de déplacement du sujet pendant l'acquisition des données de ligne de balayage pour les premières ou secondes données de grille d'espace k dans le cadre d'un ou plusieurs du premier balayage d'IRM et du second balayage d'IRM, comprend :
la génération des données de grille d'espace k delta où chaque point représente une différence entre des points correspondants dans les premières données de grille d'espace k et les secondes données de grille d'espace k ; pour chaque rangée des données de grille d'espace k delta, la détermination d'une valeur d'écart type basée sur les données de chaque telle rangée ; et
l'identification de ces rangées des données de grille d'espace k delta où la valeur d'écart type applicable est supérieure à un seuil.

4. Procédé mis en oeuvre par ordinateur selon la revendication 1, dans lequel :
la génération des premières données de grille d'espace k corrigées à l'aide des secondes données de grille d'espace k comprend le remplacement d'une ligne de balayage de la première grille d'espace k par une ligne de balayage correspondante dans la seconde grille d'espace k si le déplacement du sujet s'est produit pendant le premier balayage d'IRM ; et
la génération de secondes données de grille d'espace k corrigées à l'aide des premières données de grille d'espace k comprend le remplacement d'une ligne de balayage de la seconde grille d'espace k par une ligne de balayage correspondante dans la première grille d'espace k si le déplacement du sujet s'est produit pendant le second balayage d'IRM.

5. Procédé mis en oeuvre par ordinateur selon la revendication 1, dans lequel la génération d'une image IRM comprend l'un parmi :
le calcul de la moyenne des premières données d'espace k corrigées et des secondes données d'espace k ;
le calcul de la moyenne des premières données d'espace k corrigées et des secondes données d'espace k corrigées ; et
le calcul de la moyenne des premières données d'espace k et des secondes données d'espace k
corrigées.

6. Système d'imagerie par résonance magnétique (IRM), comprenant :
un appareil d'IRM (12) comportant un corps (14) définissant un alésage (16) conçu de telle sorte qu'un sujet ou une partie de celui-ci est inséré pour l'acquisition d'une image IRM à l'aide d'un premier balayage d'IRM et d'un second balayage d'IRM ; et
un module d'acquisition (40) configuré pour obtenir les premières données de grille d'espace k associées au premier balayage d'IRM et les secondes données de grille d'espace k associées au second balayage d'IRM ; et
un capteur de mouvement configuré pour détecter le déplacement du sujet ; et
un module de correction de mouvement (42) configuré pour :
identifier (58,60), sur la base des premières et secondes données de grille d'espace k, au moins un cas de déplacement du sujet pendant l'acquisition des données de ligne de balayage pour les premières ou secondes données de grille d'espace k dans le cadre d'un ou plusieurs du premier balayage d'IRM et du second balayage d'IRM ;
déterminer (62), à l'aide du capteur de mouvement (34), pour chaque cas identifié de déplacement du sujet, si le déplacement du sujet s'est produit pendant le premier balayage d'IRM ou le second balayage d'IRM ;
générer (64) au moins l'une parmi : les premières données de grille d'espace k corrigées à l'aide des secondes données de grille d'espace k et les secondes données de grille d'espace k corrigées à l'aide des premières données de grille d'espace k ; et
générer (66) une image IRM basée sur l'une parmi : les premières données d'espace k corrigées et les secondes données d'espace k ; les premières données d'espace k corrigées et les secondes données d'espace k corrigées ; et les premières données d'espace k et les secondes données d'espace k corrigées.

7. Système d'IRM selon la revendication 6, dans lequel le premier balayage d'IRM et le second balayage d'IRM sont consécutifs.

8. Système d'IRM selon la revendication 6, dans lequel le module de correction de mouvement (42) est en outre configuré pour :
générer des données de grille d'espace k delta où chaque point représente une différence entre les points correspondants dans les premières données de grille d'espace k et les secondes données de grille d'espace k ;
pour chaque rangée des données de grille d'espace k delta, déterminer une valeur d'écart type sur la base des données de chaque telle rangée ; et
identifier ces rangées des données de grille d'espace k delta où la valeur d'écart type applicable est supérieure à un seuil.

9. Système d'IRM selon la revendication 6, dans lequel le module de correction de mouvement est en outre configuré pour :
générer des premières données de grille d'espace k corrigées à l'aide des secondes données de grille d'espace k en remplaçant une ligne de balayage de la première grille d'espace k par une ligne de balayage correspondante dans la seconde grille d'espace k si le déplacement du sujet s'est produit pendant le premier balayage d'IRM ; et
générer des secondes données de grille d'espace k corrigées à l'aide des premières données de grille d'espace k en remplaçant une ligne de balayage de la seconde grille d'espace k par une ligne de balayage correspondante dans la première grille d'espace k si le déplacement du sujet s'est produit pendant le second balayage d'IRM.

10. Système d'IRM selon la revendication 6, dans lequel le module de correction de mouvement est en outre configuré pour générer une image IRM par l'un parmi :
le calcul de la moyenne des premières données d'espace k corrigées et des secondes données d'espace k ;
le calcul de la moyenne des premières données d'espace k corrigées et des secondes données d'espace k corrigées ; et
le calcul de la moyenne des premières données d'espace k et des secondes données d'espace k corrigées.

11. Support non transitoire lisible par ordinateur
comprenant des instructions pour amener le système d'IRM selon la revendication 6 à exécuter les étapes du procédé selon la revendication 1.

12. Support non transitoire lisible par ordinateur selon la revendication 11, dans lequel le premier balayage d'IRM et le second balayage d'IRM sont consécutifs.

13. Support non transitoire lisible par ordinateur selon la revendication 11, dans lequel les instructions amènent en outre le module de correction de mouvement (42) à identifier, sur la base des premières et secondes données de grille d'espace k, au moins un cas de déplacement du sujet pendant l'acquisition de données de lignes de balayage pour les premières ou secondes données de grille d'espace k dans le cadre d'un ou plusieurs du premier balayage d'IRM et du second balayage d'IRM par :
la génération des données de grille d'espace k delta où chaque point représente une différence entre des points correspondants dans les premières données de grille d'espace k et les secondes données de grille d'espace k ;
pour chaque rangée des données de grille d'espace k delta, la détermination d'une valeur d'écart type basée sur les données de chaque telle rangée ; et
l'identification de ces rangées des données de grille d'espace k delta où la valeur d'écart type applicable est supérieure à un seuil.

14. Support non transitoire lisible par ordinateur selon la revendication 11 dans lequel les instructions amènent en outre le module de correction de mouvement (42) à :
générer des premières données de grille d'espace k corrigées à l'aide des secondes données de grille d'espace k en remplaçant une ligne de balayage de la première grille d'espace k par une ligne de balayage correspondante dans la seconde grille d'espace k si le déplacement du sujet s'est produit pendant le premier balayage d'IRM ; et
générer des secondes données de grille d'espace k corrigées à l'aide des premières données de grille d'espace k par une ligne de balayage de la seconde grille d'espace k avec une ligne de balayage correspondante dans la première grille d'espace k si le déplacement du sujet s'est produit pendant le second balayage d'IRM.

15. Support non transitoire lisible par ordinateur selon la revendication 11, dans lequel les instructions amènent en outre le module de correction de mouvement (42) à calculer la moyenne parmi :
les premières données d'espace k corrigées et les secondes données d'espace k ;
les premières données d'espace k corrigées et les secondes données d'espace k corrigées ;
et les premières données d'espace k et les secondes données d'espace k corrigées.
